(19) Europäisches Patentamt

European Patent Office

Office européen des brevets

(11) **EP 3 675 354 A1**

(12) **EUROPEAN PATENT APPLICATION**

(43) Date of publication:
01.07.2020 Bulletin 2020/27

(51) Int Cl.:
*H03D 7/14* (2006.01)    *H03D 7/16* (2006.01)

(21) Application number: 18248223.2

(22) Date of filing: 28.12.2018

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
KH MA MD TN

(71) Applicant: Infineon Technologies AG
85579 Neubiberg (DE)

(72) Inventors:
• PIOTTO, Lorenzo
  9500 Villach (AT)
• DAL MAISTRO, Daniele
  9500 Villach (AT)

(74) Representative: Sticht, Andreas
Kraus & Weisert
Patentanwälte PartGmbB
Thomas-Wimmer-Ring 15
80539 München (DE)

(54) **MIXER DEVICE AND METHODS FOR MIXING A SIGNAL**

(57)    Mixer devices and associated methods are discussed. The mixer device comprises at least first and second current mode logic flip-flops (11, 12) coupled together to form a frequency divider. An input signal (ACin) having an input signal frequency and a clock signal (clkin) are supplied to the first and second current mode logic flip-flops, and output signals (mixout1, mixout2) based on a mixing of the input signal with a local oscillator signal derived from the clock signals are tapped from the flip-flops.

Fig. 1

**Description**

TECHNICAL FIELD

The present application relates to mixer devices for mixing an input signal with local oscillator signals and to corresponding methods.

BACKGROUND

So-called IQ mixers are electronic devices that mix an AC input signal with two orthogonal local oscillator signals, i.e. two local oscillator signals having a phase shift of 90° with respect to each other, to obtain so-called I and Q (In-phase and Quadrature) components. Such IQ mixers are used in various communication systems. In some applications, they are used for frequency downconversion, where the input signal is a radio frequency signal, which by the mixing with the local oscillator signals is downconverted to an intermediate frequency, a baseband frequency or to DC in case the local oscillator signals have the same frequency as the input signal. In other embodiments, a frequency upconversion may be implemented by mixing an AC input signal with a local oscillator signal of a higher frequency.
Applications of such mixers include applications where amplitude and phase of an analog signal is to be characterized, for example in communication systems, biomedical systems or radar systems. In this case, IQ mixers may serve as detectors for obtaining amplitude and phase.
In conventional implementations, such a mixer device comprises a circuit part which generates the two orthogonal local oscillator signals. Furthermore, the mixer device conventionally comprises two mixers, for example based on Gilbert cells, where the actual mixing of the AC input signal with a respective one of the orthogonal local oscillator signals takes place. Such conventional implementations may require a comparatively large chip area.

SUMMARY

A mixer device as defined in claim 1 and a method as defined in claim 14 are provided. The dependent claims define further embodiments.
According to an embodiment, a mixer device is provided, comprising:

at least a first current mode logic flip-flop and a second current mode logic flip-flop coupled together to form a frequency divider,
a clock input coupled to the first and second current mode logic flip-flops to supply a clock signal to the first and second current mode logic flip-flops,
a signal input configured to provide an input signal having an input signal frequency to the first and second current mode logic flip-flops, and
signal outputs coupled to the first and second current mode logic flip-flops configured to output mixed output signals which are based on a mixing of the input signal with local oscillator signals derived from the clock signal.

According to another embodiment, a method of operating a mixer device is provided, wherein the mixer device comprises at least a first current mode logic flip-flop and a second current mode logic flip-flop coupled together to form a frequency divider, the method comprising:

supplying a clock signal to the first and second current mode logic flip-flops,
providing an input signal having an input signal frequency to the first and second current mode logic flip-flops,
tapping output signals from the first and second current mode logic flip-flops which are based on a mixing of the input signal with a local oscillator signal derived from the clock signal.

The above summary is intended to give a brief overview over some embodiments and is not to be construed as limiting in any way.

BRIEF DESCRIPTION OF THE DRAWINGS

Fig. 1 is a block diagram of a mixer device according to an embodiment.

Fig. 2 is a circuit diagram illustrating an example current mode logic flip-flop usable in embodiments.

Figs. 3A and 3B are circuit diagrams illustrating the use of a current mode logic flip-flop as a mixer according to some embodiments.

Fig. 4 is a circuit diagram illustrating a mixer device according to an embodiment.

Fig. 5 is a circuit diagram illustrating a mixer device according to an embodiment.

Fig. 6 is a circuit diagram of a mixer device according to an embodiment.

Fig. 7 is an application example for mixer devices according to some embodiments.

Fig. 8 is a flow chart illustrating a method according to an embodiment.

DETAILED DESCRIPTION

In the following, various embodiments will be described referring to the attached drawings. These embodiments are given for illustrative purposes only and are not to be construed as limiting. For example, while specific circuits are shown, in other embodiments other circuits may be used to implement the described functions. Furthermore, in addition to the features and components explicitly shown and described, other features or components, for example features or components used in conventional mixer devices, may be provided.

Features from different embodiments may be combined to form further embodiments unless noted otherwise. Variations and modifications described with respect to one of the embodiments may also be applied to other embodiments and will therefore not be described repeatedly.

References to connections or couplings between components, unless noted otherwise, refer to electrical connections or couplings over which electrical signals may be transmitted. Connections or couplings may be modified as long as the general purpose of the connection or coupling, for example to transmit a certain kind of signal between components, is essentially maintained.

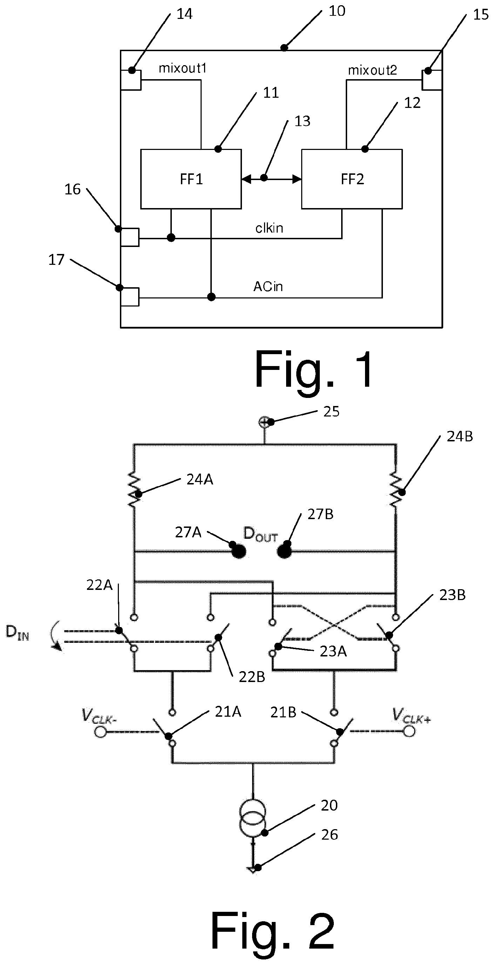

Fig. 1 is a block diagram of a mixer device 10 according to some embodiments. Mixer device 10 comprises a first current mode logic (CML) flip-flop 11 and a second current mode logic flip-flop 12. A current mode logic flip-flop is a flip-flop operating based on current signals. An example for a current mode logic flip-flop usable as flip-flop 11 and/or flip-flop 12 is shown in Fig. 2.

The current mode logic flip-flop of Fig. 2 is coupled between a more negative voltage at 26, for example ground, and a more positive voltage at 25, for example a positive supply voltage like VCC or VDD. A current source 20 provides a bias current to the current mode logic flip-flop of Fig. 2. The flip-flop of Fig. 2 receives a clock signal $V_{CLK+}$, $V_{CLK-}$ at a clock input pair of switches 21A, 21B, and a differential $D_{IN}$ received at a differential input pair of switches 22A, 22B. $V_{CLK+}$ and $V_{CLK-}$ are inverted with respect to each other. Furthermore, the current mode flip-flop of Fig. 2 comprises a cross-coupled pair of switches 23A, 23B forming a latch. When the clock signal $V_{CLK+}$, $V_{CLK-}$ is applied, switches 21A, 21B are opened and closed in an alternating manner, such that the bias current from current source 20 is supplied to switches 22A, 22B in one phase of operation and two switches 23A, 23B in another phase of operation. Switches 22A to 23B are coupled to the more positive voltage at 25 via resistors 24A, 24B, as shown, which serve to convert a current output from the switches to an output voltage signal $D_{OUT}$ which can be tapped at outputs 27A and 27B. The signal levels at output 27A, 27B are inverted with respect to each other. The inputs for signals $D_{IN}$ and $V_{CLK}$ and outputs 27A, 27B where signal $D_{OUT}$ may be tapped are also referred to as inverting and non-inverting inputs or outputs, respectively, depending on whether the signal or an inverted version thereof is provided at the respective input or output. It should be noted that the polarity of the clock signal $V_{CLK+}$, $V_{CLK-}$ does not have an impact on the polarity of $D_{IN}$ and $D_{OUT}$. The clock signal $V_{CLK+}$, $V_{CLK-}$ determines when the input signal $D_{IN}$ is sampled by switches 22A, 22B and when the output signal $D_{OUT}$ is latched by switches 23A, 23B. The side of switches 22A to 23B coupled to the relatively lower voltage at 26 is also referred to as tale side herein.

Switches 21A, 21B, 22A, 22B, 23A, 23B may be implemented as transistors like bipolar transistors, field-effect transistors like MOSFETs or insulated gate bipolar transistors (IGBTs). Switches, for example transistors, are described as closed or on if they provide an electric connection between their terminals, and are described as open or off if they are in a state where they provide essentially an electric isolation between their terminals (apart from leakage currents which may occur in some switch implementations). In case of bipolar current switches as used in embodiments discussed below, bipolar transistors may be operated in an active region and behave like a current buffer (similar to a Cascode), having a high output impedance. While in these embodiments bipolar transistors are used as an example, it is to be understood that in other embodiments other kinds of switches, in particular other kinds of transistors, may be used.

Furthermore, while a specific implementation of a current mode logic flip-flop is shown in Fig. 2 and will be used as an example herein, other conventional implementations and variations of current mode logic flip-flops may also be used.

Returning to Fig. 1, flip-flops 11, 12 are coupled in a negative feedback configuration, as indicated by an arrow 13, to form a frequency divider. In a negative feedback configuration data outputs of one flip-flop are coupled with data inputs of the other flip-flop.

In particular, using the flip-flop of Fig. 2 as an example, output 27A of flip-flop 11 may be coupled to the input controlling switch 22A of flip-flop 12, and output 27B of flip-flop 11 may be coupled to the input controlling switch 22B of flip-flop 12. To provide the negative feedback, furthermore output 27A of flip-flop 12 is coupled to the input controlling switch 22B of flip-flop 11, and output 26B of flip-flop 12 is coupled to the input controlling switch 22A of flip-flop 11. Such negative feedback between current mode logic flip-flops is conventionally used to form a current mode logic divider dividing a clock frequency of a clock signal by two.

In Fig. 1, such a clock signal clkin, which may correspond to the clock signal $V_{CLK-}$, $V_{CLK+}$ in Fig. 2, is provided at a clock input 16. Such a current mode logic divider generates two output signals at the two flip-flops which have a phase offset of 90° to each other. In conventional mixer devices, such signals may then be provided to separate mixer circuits, where they are mixed with an input signal.

In embodiments, essentially the current mode logic flip-flops 11, 12 are themselves used as mixer circuits, such that no additional mixer circuits need to be provided. To this end, an AC input signal ACin to be mixed with a local oscillator signal having half the frequency of clock signal clkin is provided at an AC input 17. An AC input signal generally refers to a signal having a certain input signal frequency, in contrast to a direct current (DC) signal. The signal ACin is provided to flip-flops 11, 12, in particular to tail ends thereof, i.e. to a side of switches 21A to 23B coupled to the more negative voltage at 26. Various examples for such a coupling will be explained further below. From flip-flops 11, 12 the mixed output signals mixout1, mixout2 may be tapped. Depending on the frequency of the input signal ACin and the frequency of the clock signal clkin in Fig. 1, mixed signals mixout1, mixout2 may be upconverted or downconverted versions of signal ACin. If a frequency of signal ACin corresponds to half the frequency of the clock signal clkin (as the clock signal is divided by two by flip-flops 11, 12 for mixing), signals mixout1, mixout2 are DC signals. Otherwise, the signals may be AC signals at an intermediate frequency (IF).

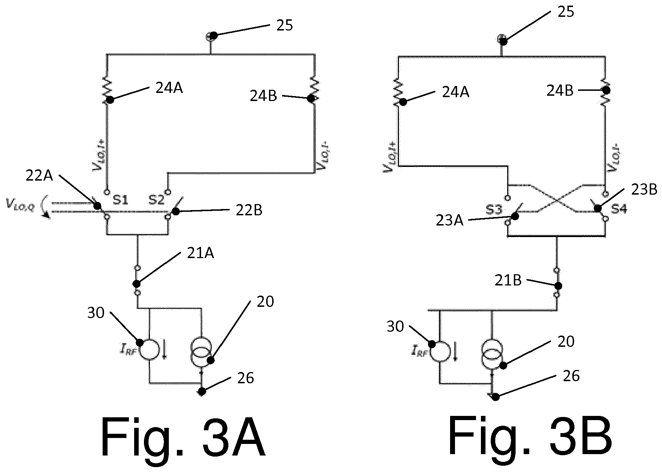

While two flip-flops 11, 12 coupled in a negative feedback configuration to form a frequency divider with a division factor of 2 are used as an example herein, in other embodiments a plurality of flip-flops may be coupled in other divider configurations generally having a division factor of N, wherein N is an integer or non-integer number. Flip-flops may also be coupled in a programmable divider configuration where N is adjustable. Also in this case, the flip-flops may be seen as incorporating a mixer as explained below with reference to Figs. 3A and 3B, and this may be used to provide a mixer device where no additional mixer circuit is needed in some embodiments. In this case, for obtaining a DC mixed signal as an output signal, a frequency of a clock signal provided to the mixer device may be N times the frequency of the AC input signal.

The term "mixed signal" as used herein refers to the result of the mixing process, i.e. mixing the AC input signal with the local oscillator signal, and is not to be confused with the term "mixed signal" sometimes used to refer to circuits and devices using both analog and digital signals.

The concept of using a current mode logic flip-flop as a mixer will now be explained referring to Figs. 3A and 3B.

Fig. 3A essentially shows the flip-flop of Fig. 2 in a phase where switch 21A is closed and switch 21B is open, and Fig. 3B shows the flip-flop of Fig. 2 in a phase where switch 21A is open and switch 21B is closed. Elements corresponding to the flip-flop of Fig. 2 bear the same reference numeral and will not be described again in detail.

In addition to the bias current of current source 20, a current $I_{RF}$ representing a radio frequency (RF) signal to be mixed is provided in addition to the bias current as symbolized by RF current source 30. Various techniques for injecting an RF current based on an RF signal will be explained further below. It should be noted that while RF signals will be used as an example of AC input signals in the following embodiments, which are then downconverted, also other signals like baseband frequency signals may be used, which may then be upconverted by mixing.

In the phase shown in Fig. 3A, a local oscillator signal $V_{LO,Q}$ is applied to switches 22A, 22B, which, as will be described later, in embodiments is generated by dividing an input clock signal.

The structures of Figs. 3A and 3B essentially correspond to a single balanced mixer, where the RF signal is mixed with the local oscillator signal. Based on this finding, as already briefly explained with respect to Fig. 1 and as will be explained in further detail below, the two flip-flops 11, 12 coupled in a negative feedback configuration may not only be used for generating local orthogonal oscillator signals offset by a 90° phase difference, but in embodiments are also used as mixers. Therefore, in such embodiments no additional mixer circuits are needed, which may safe area and costs.

In other words, as can be seen from Figs. 3A and 3B, a current mode logic divider made of two current mode logic flip-flops already contains essentially two single balanced mixers, which in embodiments are used for mixing, without the need for additional mixer circuits.

It should be noted that while the highest mixing efficiency is obtained if the signal to be mixed ($I_{RF}$ in Figs. 3A and 3B) is supplied in both phases shown in Figs. 3A and 3B, mixing, albeit with less efficiency, is also obtained when the signal to be mixed is supplied only in one of the phases. Therefore, such arrangements are also to be considered as embodiments disclosed herein.

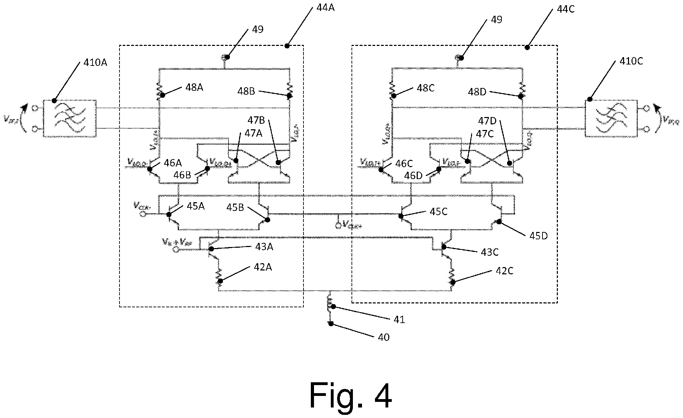

Fig. 4 illustrates a mixer device according to an embodiment. To avoid repetitions, when describing the embodiment of Fig. 4, reference will be made to the previously described figures.

In the embodiment of Fig. 4, a first current mode logic flip-flop 44A and a second current mode logic flip-flop 44C are provided which are coupled in a negative feedback configuration to essentially form a current mode logic divider. In flip-flops 44A and 44C, switches are implemented as bipolar transistors. As already mentioned, in other embodiments other kinds of transistors may be used.

The general structure of flip-flops 44A, 44C is identical, except for differences explicitly described below. Therefore, only first current mode logic flip-flop 44A will be described in detail below, and the description applies also to second current mode logic flip-flop 44C. Elements in second current mode logic flip-flop 44C which correspond to elements of first current mode logic flip-flop 44A bear the same reference numerals, with an "A" replaced by a "C" and a "B" replaced by a "D" (i.e. component 45C in flip-flop 44C corresponds to component 45A in flip-flop 44A, component 45D in flip-flop 44C corresponds to component 45B in flip-flop 44A etc.).

Both flip-flops 44A, 44C are coupled between a more negative voltage at 40, for example ground, and a more positive voltage at 49, for example a positive supply voltage like VCC or VDD. Other voltages may also be used. Flip-flops 44A, 44C are coupled to the more negative voltage at 40 via an inductor 41 in the embodiment of Fig. 4. Inductor 41 may in some implementations linearize a transconductance on the input side (clock input at differential pairs 45A, 45B and 45C, 45D and inputs at differential pairs 46A, 46B and 46C, 46D).

Flip-flop 44A comprises a bias current source formed by a resistor 42A and a transistor 43A coupled in series to inductor 41 as shown. Transistor 43A is controlled by a voltage, which has a constant component $V_B$ for providing a constant bias current plus a voltage $V_{RF}$ corresponding to a radio frequency (RF) input signal. Radio frequency (RF) may refer to frequencies greater than 9 kHz, or also in particular to frequencies used in communication systems, which are in the Megahertz or even Gigahertz range. As already mentioned, using an RF signal as an AC input signal is merely an example, and other input frequencies may also be used for the AC input signal.

Transistor 43A is biased by bias voltage $V_B$ in a range below saturation, in particular in a linear range of transistor 43A, such that the bias current generated is modulated according to the voltage $V_{RF}$.

This modulated bias current is provided to a differential pair 45A, 45B of flip-flop 44A serving as a clock input pair of switches. A clock signal $V_{CLK+}$ is supplied to a base terminal of transistor 45B, and the inverted clock signal $V_{CLK-}$ is supplied to a base terminal of transistor 45A. It should be noted that in flip-flop 44C, $V_{CLK+}$ is supplied to the base terminal of transistor 45C, and $V_{CLK-}$ is supplied to the base terminal of transistor 45D. Transistors 45A, 45B are an implementation example of switches 21A, 21B of Fig. 2.

A collector terminal of transistor 45A is coupled to a differential input pair of transistors 46A, 46B, which are an implementation example for switches 22A, 22B in Fig. 2. As will be explained further below, base terminals of transistors 46A, 46B are coupled to second flip-flop 44C, and base terminals of corresponding transistors 46C, 46D of second flip-flop 44C are coupled to first flip-flop 44A as will be explained further below, to provide a negative feedback between the flip-flops.

Furthermore, a collector terminal of transistor 45B is coupled with cross-coupled transistors 47A, 47B, which are an implementation example for switches 43A, 43B of Fig. 2 forming a latch.

Collector terminals of transistors 46A and 47A are coupled to the more positive voltage at 49 via a resistor 48A, and collector terminals of transistors 46B, 47B are coupled to the more positive voltage at 49 via a resistor 48B.

In case of Fig. 4, the tale sided of flip-flop 44A mentioned with respect to Fig. 2 corresponds to the emitter side of transistors 46A to 47B.

Next, the coupling of flip-flops 44A, 44C in a negative feedback configuration will be briefly described. The connections for this negative feedback couplings are not explicitly shown in Fig. 4 for clearness of representation, but are instead indicated by respective signals. A voltage between transistor 46A and resistor 48A is labelled $V_{LO,I+}$ in Fig. 4 and is provided to the base terminal of transistor 46C. A voltage between transistor 46B and resistor 48B in Fig. 4 is labelled $V_{LO,I-}$ and is provided to a base terminal of transistor 46D. A voltage between transistor 46C and resistor 48C is labelled $V_{LO,Q+}$ and is provided to a base terminal of transistor 46B. A voltage between transistor 46D and resistor 48D is labelled $V_{LO,Q-}$ and is provided to a base terminal of transistor 46A. The designation $V_{LO}$ will be used herein to jointly refer to $V_{LO,I+}$, $V_{LO,I-}$, $V_{LO,Q+}$ and $V_{LO,Q-}$. This coupling corresponds to the coupling in a conventional current mode logic divider. Without the presence of signal $V_{RF}$, each of signal pairs $V_{LO,I+}$, $V_{LO,I-}$ and $V_{LO,Q+}$, $V_{LO,Q-}$ has a frequency half the frequency of clock signal $V_{CLK+}$, $V_{CLK-}$, and the two pairs are phase offset with respect to each other by 90° and form local oscillator (LO) signals.

With the addition of the radio frequency signals $V_{RF}$, the signals $V_{LO+}$, $V_{LO-}$ and $V_{LO,Q+}$ and $V_{LO,Q-}$ have also a component which corresponds to $V_{RF}$ mixed with the respective local oscillator signal. In the embodiment of Fig. 4, these signals $V_{IF,I}$ and $V_{IF,Q}$, jointly referred to as $V_{IF}$, are extracted using low pass filters 410A, 410C, respectively. Low pass filters 410A, 410C serve to reject signal components at the local oscillator frequency, which corresponds to half a frequency of $V_{CLK+}$, $V_{CLK-}$, and at the radio frequency of $V_{RF}$, to let only signals $V_{IF,I}$ and $V_{IF,Q}$ at the intermediate frequency pass. The intermediate frequency IF depends on the frequency of half the frequency of the clock signal and the frequency of the RF signal $V_{RF}$. In case the frequency of the clock signal is twice the frequency of the RF signal such that the local oscillator frequency corresponds to the RF frequency, the intermediate frequency is essentially zero, such that $V_{IF,I}$ and $V_{IF,Q}$ are DC signals. It should be noted that in cases where the mixer device is used for upconversion, where the AC input signal has a comparatively low frequency and is mixed with a local oscillator signal of a higher frequency, instead of low pass filters 410A, 410C for example high pass filters or bandpass filters may be provided to extract the intermediate frequency signals at the corresponding intermediate frequency.

As can be seen, in the embodiment of Fig. 4 no separate mixer circuits are needed, but the flip-flops 44A, 44C coupled in a negative feedback configuration serve both for generating local oscillator signals offset by 90° and for mixing. Therefore, compared to some conventional solution, chip area may be saved.

In the embodiment of Fig. 4, the RF signal $V_{RF}$ is coupled into flip-flops 44A, 44C by modifying the bias current, as explained. Furthermore, the signals $V_{IF,I}$ and $V_{IF,Q}$ are extracted using low pass filters 410A, 410C. These serve only as examples, and other circuits may also be used for coupling an AC input signal into the mixer device and for extracting the mixed signals from the mixer device. Generally, the RF signal may be injected anywhere on the tail side of flip-flops 44A, 44C and, as already mentioned with respect to Figs. 3A and 3C, in some embodiments may be injected only to differential input pairs 46A, 46B and 46C and 46D or only to cross-coupled pairs 47A, 47B and 47C, 47D, even if this may reduce mixing efficiency in some implementations.

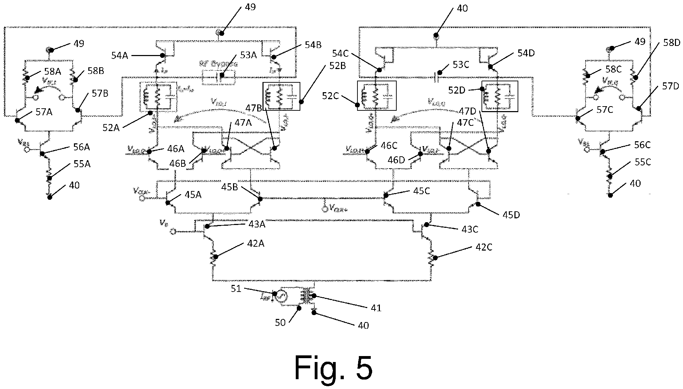

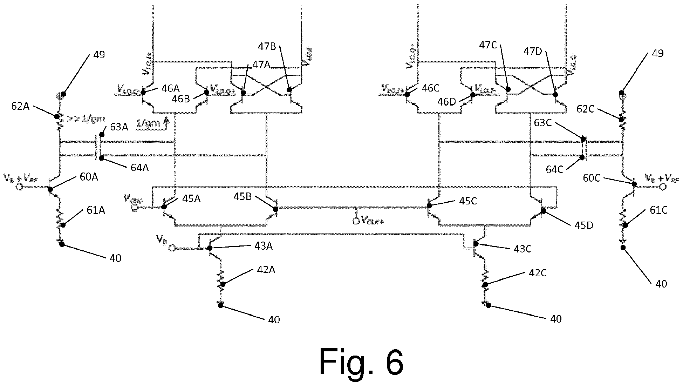

Further examples for coupling the RF signal into the flip-flops and extracting the mixed signals from the flip-flops will be explained with reference to Figs. 5 and 6. Mixer devices shown in Figs. 5 and 6 are modifications of the mixer device of Fig. 4, and corresponding elements bear the same reference numerals and will not be described again in detail. Furthermore, the convention that components for the second flip-flop or associated with the second flip-flop which correspond to components of the first flip-flop or associated with the first flip-flop bear the same reference numerals with "A" replaced by a "C" and "B" replaced by a "D" also apply to the embodiments of Figs. 5 and 6, so the components will only be described in detail for one of the flip-flops.

In the mixer device of Fig. 5, both the incoupling of the RF signal to be mixed and the outcoupling of the mixed signals is modified compared to Fig. 4. It should be noted that these modifications may be implemented independently from each other, i.e. some embodiments may comprise only the incoupling circuit of Fig. 5 or only the outcoupling circuit of Fig. 5, as described below.

In Fig. 5, an RF current signal $I_{RF}$ to be mixed generated by some RF current source 51 is coupled into the mixer device using a transformer comprising the already mentioned inductor 41 as a secondary side inductor and an inductor 50 as a primary side inductor of the transformer. RF current source 51 may be any device generating the RF current $I_{RF}$. For example, in communication applications the RF current $I_{RF}$ may be derived from an RF signal received at an antenna.

In some embodiments, by using a transformer to couple the RF signal into the mixer device, the incoupling is decoupled from the divider itself and its bias current source, which in some implementations may facilitate design of the input side and its transconductance (clock input at differential pairs 45A, 45B and 45C, 46D and input at differential pairs 46A, 46B and 46C, 46D).

Furthermore, the mixer device of Fig. 5 shows an outcoupling circuit for coupling out mixed signals $V_{IF,I}$ and $V_{IF,Q}$, which in some implementations may improve decoupling between the generation of the local oscillator signals in signals $V_{LO}$ from the clock signals $V_{CLK}$ and the intermediate frequency signals $V_{IF}$, in particular if the intermediate frequency is at or near DC. This circuit will be described in detail for the first flip-flop, and is built in a corresponding manner for the second flip-flop.

Compared to Fig. 4, resistor 48A is replaced by a series connection of a resonant circuit 42A and a diode coupled transistor 45A. Likewise, resistor 48B is replaced by a series connection of a resonance circuit 42B and a diode coupled transistor 45B. Resonant circuits 52A and 52B each comprise an inductor, a resistor and a capacitor coupled in parallel. Other resonant circuit configurations may also be used. Inductance, capacitance and resistor values of resonant circuits 52A, 52B are selected such that the resonance frequency $f_0$ of resonant circuits 52A, 52B is at or near a frequency $f_{RF}$ of the radio frequency input current $I_{RF}$ in the embodiment of Fig. 5.

Additionally, an RF bypass capacitor 53A is provided coupling a node between resonant circuit 52A and transistor 54A with a node between resonant circuit 52B and transistor 54B. Capacitor 53A essentially serves as a high pass filter which blocks low frequency and in particular DC signals while essentially let currents with the RF frequency $f_{RF}$ pass.

By this design, the resonators 52A, 52B have low impedance at low frequency, in particular DC, and at two times the local oscillator frequency, i.e. at the frequency of clock signal $V_{CLK}$. This in some implementations allows a lower sensitivity of the local oscillator signal generation against the mixing products. In other words, the mixing in such an implementation may constitute a lower disturbance for the generation of the local oscillator signals.

The intermediate frequency signal $V_{IF,I}$ is then coupled out using a translinear circuit 54 to 58 coupled between the relatively lower voltage at 40 and the relatively higher voltage at 49. In the example of Fig. 5, the translinear circuit comprises a bias current source including a resistor 55A and a transistor 56A biased with a bias voltage $V_{BI}$. The bias current thus generated is provided to a differential pair of transistors 57A, 57B. A base terminal of transistor 57A is coupled to the node between resonant circuit 52B and transistor 54B, and a base terminal of transistor 57B is coupled to the node between resonant circuit 52A and transistor 55A. Collectors of transistors 57A, 57B are coupled to the relatively higher voltage at 49 via resistors 48A, 48B. The mixed signal $V_{IF,I}$ may then be tapped between a node between transistor 57A and resistor 58A and a node between transistor 57B and resistor 58B as shown. A similar translinear circuit is provided coupled to the second flip-flop for tapping mixed signal $V_{IF,Q}$.

A further possibility of coupling in an RF signal in a mixer device is illustrated in Fig. 6.

In Fig. 6, the first and second flip-flops are only partially shown. In particular, the outcoupling of the mixed signals $V_{IF,I}$ and $V_{IF,Q}$ is omitted and may for example be implemented as shown in Fig. 4 or Fig. 5.

Again, in Fig. 6 the incoupling of the RF signal will be described for the first flip-flop, and the explanations apply to the second flip-flop in a corresponding manner.

In the embodiment of Fig. 6, the radio frequency signal $V_{RF}$ is coupled into the flip-flops between the clock input differential pairs 55A, 55B and the transistors 46A to 47B for the first flip-flop. For coupling, an incoupling circuit is provided. The incoupling circuit comprises a first resistor 61A, a transistor 60A and a second resistor 62A coupled in series between the relatively lower voltage at 40 and the relatively higher voltage at 49. Transistor 60A is biased with a bias voltage $V_B$ biasing the transistor below saturation, in particular in a linear range, plus the radio frequency input signal $V_{RF}$. A node between transistor 60A and resistor 62A is coupled to a node between transistor 45A and differential pair 46A, 46B via a capacitor 63A and to a node between transistor 45B and transistors 47A, 47B via a capacitor 64A. capacitors 63A, 64E serve for DC de-coupling and are designed such that they provide a small impedance at the frequency of radio frequency signal $V_{RF}$.

A resistance value of resistor 62A in the embodiment of Fig. 6 may be chosen to be significantly larger (for example at least ten times, at least 100 times or at least 1000 times) then the transconductance gm of differential pair 46A, 46B.

Therefore, as can be seen from Figs. 4 to 6, there are various possibilities both for coupling in a signal to be mixed, for example the RF signal, and for coupling out the result of the mixing, i.e. the mixed signal.

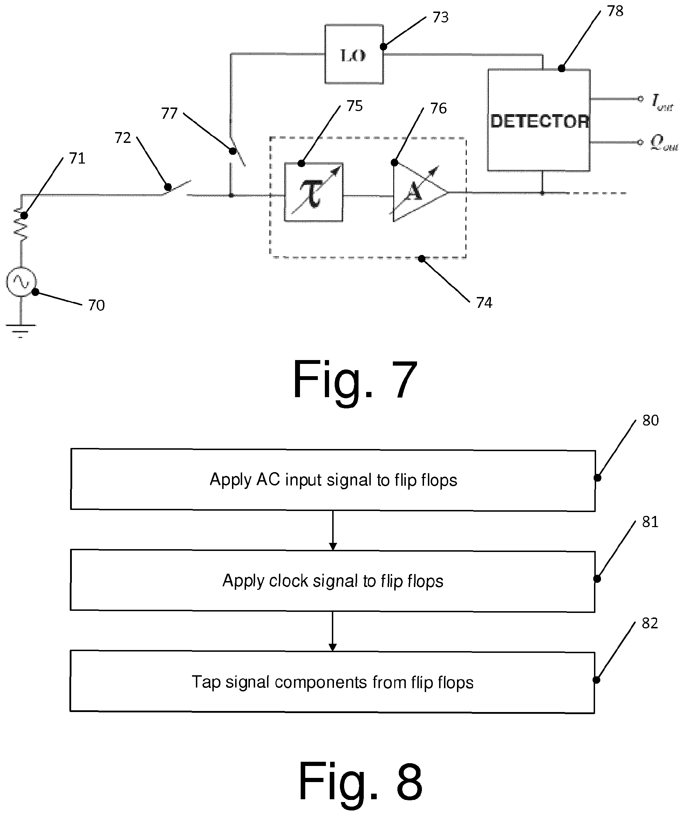

Mixer devices as discussed previously may for example be used for calibration purposes in communication systems like phased array systems, where radio frequency signals are provided to antennas with antenna-specific delays and amplitudes for beam forming purposes. An example for such an application is shown in Fig. 7. However, it is to be noted that this is only an application example, and mixer devices as discussed above may be used generally when an AC input signal is to be mixed with two orthogonal local oscillator signals to provide I and Q components of a mixed signal.

In the application example of Fig. 7, an RF radio frequency channel 74 comprising an adjustable delay element 75 and an adjustable amplifier 76 is to be tested and/or calibrated. Via adjustable delay element 75, a phase of an RF signal provided to RF channel 74 is adjusted, and via adjustable amplifier 76, the amplitude is adjusted. The testing or calibrating the RF channel 74 in some application requires detecting phase and amplitude of the signal output by RF channel 74, for example for various settings of adjustable delay element 75 and adjustable amplifier 76.

In the example of Fig. 7, an RF reference signal is provided by an RF source 70 coupled to a resistor 71. Via a switch 72, this test signal is supplied to RF channel 74. Furthermore, via a switch 77 the RF test signal may be supplied to an internal reference generation circuit 73 to generate a clock signal for a detector 78 from which the local oscillator signal is derived. For example, internal reference generation circuit 73 may comprise a phase-locked loop (PLL) configured to output a clock signal having twice the frequency of the RF test signal, such that after a division by two a local oscillator signal has the same frequency as the RF test signals. Other configurations for generating a clock signal and an RF test signal may also be used, as long as it may be ensured that for testing purposes the signal generated by internal reference generation circuit 73 has twice the frequency of the RF test signal.

It should be noted that for testing switches 72 and 77 are closed. In normal operation, switches 72, 77 are then opened, and in this case internal reference generation circuit 73 may provide a local oscillator signal for normal operation of a circuit including RF channel 74, and an RF signal other than the test signal may be supplied to RF channel 74.

Detector 78 is a mixer device as explained with reference to Figs. 1 to 6. The signal generated from internal reference generation circuit 73 is provided to the clock input (for example a signal clkin or $V_{CLK+}$, $V_{CLK+}$ in the previous embodiments), and the output signal of RF channel 74 is provided as the RF input signal (ACin, $V_{RF}$ or $I_{RF}$ in the previous embodiments, for example).

Detector 78 then outputs DC I and Q components, labelled $I_{out}$ and $Q_{out}$ in Fig. 7. If the embodiments of Figs. 4 to 6 are used as detectors, these components correspond to the output voltages $V_{IF,I}$ and $V_{IF,Q}$, where the intermediate frequency is zero, i.e. DC. In this case, for $I_{out}$ and $Q_{out}$, the following equations apply:

$$I_{out,DC} = G_{mix} A_{IN} \cos(\phi_{LO} - \phi_{RF})$$

$$Q_{out,DC} = G_{mix} A_{IN} \sin(\phi_{LO} - \phi_{RF})$$

In the above equation, $A_{IN}$ is the amplitude of the RF signal output by RF channel 74 to detector 78, $\Phi_{RF}$ is the phase of this signal, $\Phi_{LO}$ is the phase of the local oscillator signal generated based on the signal output from reference generation circuit 73 to detector 78 and $G_{mix}$ is the mixer gain of detector 78. From these equations, phase and amplitude may be calculated as follows:

$$G_{mix} A_{IN} = \sqrt{I_{out,DC}^{2} + Q_{out,DC}^{2}}$$

$$\phi_{LO} - \phi_{RF} = \arctan\left(\frac{Q_{out,DC}}{I_{out,DC}}\right)$$

When testing the RF channel 74, $\Phi_{LO}$ and $G_{mix}$ are constants. Therefore, varying adjustable delay element 75 or adjustable amplifier 76 is directly reflected in $G_{mix}A_{IN}$ and $\Phi_{LO} - \Phi_{RF}$, and therefore RF channel 74 may be calibrated or torted.

As mentioned, Fig. 7 is merely an example application for mixer devices as discussed herein, and mixer devices may be used in a variety of applications.

Fig. 8 is a flow chart illustrating a method according to an embodiment. The method of Fig. 8 may be implemented using the embodiments discussed above with reference to Figs. 1 to 7 and, in order to avoid repetitions, will be described with respect to these embodiments. However, implementation of the method of Fig. 8 is not limited to the above-described embodiments.

While the method is described as a series of acts or events, the order in which these acts or events is shown or described is not to be construed as limiting. In particular, the various acts and events described may also be performed simultaneously in different parts of a mixer device.

At 80, the method comprises applying an AC input signal to a pair of current mode logic flip-flops coupled in a negative feedback configuration. The AC input signal may for example be signal ACin of Fig. 1 or, signal $V_{RF}$ of Figs. 4 or 6 or signal $I_{RF}$ of Fig. 5. At 81, the method comprises applying a clock signal to the flip-flops, for example signal clkin of Fig. 1 or signal $V_{CLK+}$, $V_{CLK-}$ of Figs. 4 to 6. In some embodiments, the clock signal may have twice the frequency of the AC input signal. At 82, the method comprises tapping mixed signal components (I and Q components) from the flip-flops, for example signal mixout1, mixout2 of Fig. 1 or signals $V_{IF,I}$ and $V_{IF,Q}$ of Figs. 4 to 6.

Variations and modifications described with respect to the mixer devices may also be applied to the method of Fig. 8.

Example embodiments are summarized here. Other embodiments can also be understood from the entirety of the specification and the claims filed herein.

Example 1. A mixer device (10), comprising:

at least a first current mode logic flip-flop (11; 44A) and a second current mode logic flip-flop (12; 44C) coupled together to form a frequency divider,
a clock input (16) coupled to the first and second current mode logic flip-flops (11, 12; 44A, 44C) to supply a clock signal (clkin; VCLK+, VCLK-) to the first and second current mode logic flip-flops (11, 12; 44A, 44C),
a signal input (17) configured to provide an input signal (ACin; IRF; VRF) having an input signal frequency to the first and second current mode logic flip-flops (11, 12; 44A, 44C), and
signal outputs coupled to the first and second current mode logic flip-flops (11, 12; 44A, 44C) configured to output mixed output signals (mixout1, mixout2; VIF,I, VIF,Q) which are based on a mixing of the input signal with local oscillator signals (VLO,I+, VLO,I-, VLO,Q+, VLO,Q1-) derived from the clock signal (clkin; VCLK+, VCLK-).

Example 2. The mixer device (10) of example 1, wherein the first and second current mode flip-flops (11, 12; 44A, 44C) are coupled in a negative feedback configuration.

Example 3. The mixer device (10) of example 1 or 2, wherein the frequency divider has a division factor of 2.

Example 4. The mixer device (10) of any one of examples 1-3, wherein each of the first and second current mode flip-flops (11, 12; 44A, 44C) comprises:

a clock input pair of switches (21A, 21B; 45A, 45B, 45C, 45D) coupled to the clock input (16) such that the switches of the first clock input pair of switches (21A, 21B; 45A, 45B, 45C, 45D) are open and closed in an alternating manner based on a clock signal,
a differential input pair of switches (22A, 22B; 46A, 46B, 46C, 46D) coupled to a first switch (21A, 45A, 45C) of the clock input pair of switches (21A, 21B; 45A, 45B, 45C, 45D), and
a cross-coupled pair of switches (23A, 23B; 47A, 47B, 47C, 47D) coupled to a second switch (21B; 45B, 45D) of the clock input pair of switches (21A, 21B; 45A, 45B, 45C, 45D).

Example 5. The mixer device (10) of any one of examples 1-4, wherein the mixer device comprises an outcoupling circuit (410A, 410C; 52-58) configured to reject signals components in the output signals with a frequency corresponding to the input signal frequency.

Example 6. The mixer device (10) of example 5, wherein the outcoupling circuit comprises a filter circuit (410A, 410C; 52A, 52B, 52C, 52D, 53A, 53C).

Example 7. The mixer device (10) of examples 5 or 6 and of example 4, wherein the outcoupling circuit (410A, 410C; 52A, 52B, 52C, 52D, 53A, 53C) is coupled to a side of the differential input pair of switches (22A, 22B; 46A, 46B, 46C, 46D) and the cross-coupled pair of switches (23A, 23B; 47A, 47B, 47C, 47D) on a side opposite the clock input pair of switches (21A, 21B; 45A, 45B, 45C, 45D).

Example 8. The mixer device (10) of example 7, wherein the outcoupling circuit (410A, 410C; 52A, 52B, 52C, 52D, 53A, 53C) comprises one or more resonator circuits (52A, 52B, 52C, 52D) having a resonance frequency essentially at the input signal frequency.

Example 9. The mixer device (10) of example 8, wherein the resonator circuits comprise for each current mode logic flip-flop (11, 12; 44A, 44C) a first resonator circuit (52A, 52C) and a second resonator circuit (52B, 52D), and a capacitor (53A, 53C) coupled between the first and second resonator circuits.

Example 10. The mixer device (10) of example 9, wherein the outcoupling circuit comprises a translinear circuit (55-58) for each current mode logic flip-flop (11, 12; 44A, 44C) coupled to the first and second resonator circuits (52A, 52B, 52C, 52D).

Example 11. The mixer device (10) of any one of examples 1 to 10, further comprising an incoupling circuit (41, 50; 43A; 60-64) configured to couple the input signal (ACin, IRF, VRF) to the first and second current mode logic flip-flops (11, 12; 44A, 44C).

Example 12. The mixer device (10) of example 11, wherein the incoupling circuit comprises a transformer (41, 50) configured to inductively couple the input signal (IRF) to the first and second current mode logic flip-flops (11, 12; 44A, 44C).

Example 13. The mixer device (10) of example 11 or 12, wherein the incoupling circuit is configured to modify a bias current provided to the first and second current mode logic flip-flops (11, 12; 44A, 44C) based on the input signal.

Example 14. The mixer device (10) of example 13, wherein the incoupling circuit comprises a transistor (43A, 43B) biased at least in part by the input signal (VRF).

Example 15. The mixer device (10) of any one of examples 11 to 14 and according to example 4, wherein the incoupling circuit (41, 50; 43A; 60-64) is configured to couple the input signal (IRF) at a side of the differential input pair of switches (22A, 22B; 46A, 46B, 46C, 46D) and the cross-coupled pair of switches(23A, 23B; 47A, 47B, 47C, 47D) at a side coupled to the clock input pair switches (21A, 21B; 45A, 45B, 45C, 45D).

Example 16. The mixer device (10) of example 15, wherein the incoupling circuit (41, 50; 43A; 60-64) is configured to couple the input signal to the input pair of switches (22A, 22B; 46A, 46B, 46C, 46D), the cross-coupled pair of switches (23A, 23B; 47A, 47B, 47C, 47D) or both.

Example 17. The mixer device (10) of any one of examples 1-16, wherein the frequency divider has a division factor of N, wherein a frequency of the clock signal is N times the frequency of the input signal.

Example 18. A method of operating a mixer device, wherein the mixer device comprises at least a first current mode logic flip-flop (11; 44A) and a second current mode logic flip-flop (12; 44C) coupled together to form a frequency divider, the method comprising:

supplying a clock signal (clkin, VCLK+, VCLK-) to the first and second current mode logic flip-flops (11, 12; 44A, 44C),
providing an input signal (ACin, IRF, VRF) having an input signal frequency to the first and second current mode logic flip-flops (11, 12; 44A, 44C),
tapping output signals from the first and second current mode logic flip-flops (11, 12; 44A, 44C) which are based on a mixing of the input signal (ACin, IRF, VRF) with a local oscillator signal (VLO,I+, VLO,I-, VLO,Q+, VLO,Q1-) derived from the clock signal (clkin, VCLK+, VCLK-).

Example 19. The method of example 18, wherein the mixer device (10) is the mixer device of any one of claims 1 to 17.

Example 20. The mixer device (10) of example 18 or 19, wherein the input signal is a radio frequency input signal.

Example 21. The method of any one of examples 18 to 20, wherein the frequency divider has a division factor of N, and wherein the clock signal has a frequency N times the input signal frequency.

Example 22. The method of example 21, wherein N=2.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A mixer device (10), comprising:

   at least a first current mode logic flip-flop (11; 44A) and a second current mode logic flip-flop (12; 44C) coupled together to form a frequency divider,
   a clock input (16) coupled to the first and second current mode logic flip-flops (11, 12; 44A, 44C) to supply a clock signal (clkin; $V_{CLK+}$, $V_{CLK-}$) to the first and second current mode logic flip-flops (11, 12; 44A, 44C),
   a signal input (17) configured to provide an input signal (ACin; $I_{RF}$; $V_{RF}$) having an input signal frequency to the first and second current mode logic flip-flops (11, 12; 44A, 44C), and
   signal outputs coupled to the first and second current mode logic flip-flops (11, 12; 44A, 44C) configured to output mixed output signals (mixout1, mixout2; $V_{IF,I}$, $V_{IF,Q}$) which are based on a mixing of the input signal with local oscillator signals ($V_{LO,I+}$, $V_{LO,I-}$, $V_{LO,Q+}$, $V_{LO,Q1-}$) derived from the clock signal (clkin; $V_{CLK+}$, $V_{CLK-}$).

2. The mixer device (10) of claim 1, wherein each of the first and second current mode flip-flops (11, 12; 44A, 44C) comprises:

   a clock input pair of switches (21A, 21B; 45A, 45B, 45C, 45D) coupled to the clock input (16) such that the switches of the first clock input pair of switches (21A, 21B; 45A, 45B, 45C, 45D) are open and closed in an alternating manner based on a clock signal,
   a differential input pair of switches (22A, 22B; 46A, 46B, 46C, 46D) coupled to a first switch (21A, 45A, 45C) of the clock input pair of switches (21A, 21B; 45A, 45B, 45C, 45D), and
   a cross-coupled pair of switches (23A, 23B; 47A, 47B, 47C, 47D) coupled to a second switch (21B; 45B, 45D) of the clock input pair of switches (21A, 21B; 45A, 45B, 45C, 45D).

3. The mixer device (10) of claim 1 or 2, wherein the mixer device comprises an outcoupling circuit (410A, 410C; 52-58) configured to reject signals components in the output signals with a frequency corresponding to the input signal frequency.

4. The mixer device (10) of claim 3 and of claim 2, wherein the outcoupling circuit (410A, 410C; 52A, 52B, 52C, 52D, 53A, 53C) is coupled to a side of the differential input pair of switches (22A, 22B; 46A, 46B, 46C, 46D) and the cross-coupled pair of switches (23A, 23B; 47A, 47B, 47C, 47D) on a side opposite the clock input pair of switches (21A, 21B; 45A, 45B, 45C, 45D).

5. The mixer device (10) of claim 4, wherein the outcoupling circuit (410A, 410C; 52A, 52B, 52C, 52D, 53A, 53C) comprises one or more resonator circuits (52A, 52B, 52C, 52D) having a resonance frequency essentially at the input signal frequency.

6. The mixer device (10) of claim 5, wherein the resonator circuits comprise for each current mode logic flip-flop (11, 12; 44A, 44C) a first resonator circuit (52A, 52C) and a second resonator circuit (52B, 52D), and a capacitor (53A, 53C) coupled between the first and second resonator circuits.

7. The mixer device (10) of claim 6, wherein the outcoupling circuit comprises a translinear circuit (55-58) for each current mode logic flip-flop (11, 12; 44A, 44C) coupled to the first and second resonator circuits (52A, 52B, 52C, 52D).

8. The mixer device (10) of any one of claims 1 to 7, further comprising an incoupling circuit (41, 50; 43A; 60-64) configured to couple the input signal (ACin, $I_{RF}$, $V_{RF}$) to the first and second current mode logic flip-flops (11, 12; 44A, 44C).

9. The mixer device (10) of claim 8, wherein the incoupling circuit comprises a transformer (41, 50) configured to inductively couple the input signal ($I_{RF}$) to the first and second current mode logic flip-flops (11, 12; 44A, 44C).

10. The mixer device (10) of claim 8 or 9, wherein the incoupling circuit is configured to modify a bias current provided to the first and second current mode logic flip-flops (11, 12; 44A, 44C) based on the input signal.

11. The mixer device (10) of claim 10, wherein the incoupling circuit comprises a transistor (43A, 43B) biased at least in part by the input signal ($V_{RF}$).

12. The mixer device (10) of any one of claims 8 to 11 and according to claim 7, wherein the incoupling circuit (41, 50; 43A; 60-64) is configured to couple the input signal ($I_{RF}$) at a side of the differential input pair of switches (22A, 22B; 46A, 46B, 46C, 46D) and the cross-coupled pair of switches (23A, 23B; 47A, 47B, 47C, 47D) at a side coupled to the clock input pair switches (21A, 21B; 45A, 45B, 45C, 45D).

13. The mixer device (10) of claim 12, wherein the incoupling circuit (41, 50; 43A; 60-64) is configured to couple the input signal to the input pair of switches (22A, 22B; 46A, 46B, 46C, 46D), the cross-coupled pair of switches (23A, 23B; 47A, 47B, 47C, 47D) or both.

14. A method of operating a mixer device, wherein the mixer device comprises at least a first current mode logic flip-flop (11; 44A) and a second current mode logic flip-flop (12; 44C) coupled together to form a frequency divider, the method comprising:

    supplying a clock signal (clkin, $V_{CLK+}$, $V_{CLK-}$) to the first and second current mode logic flip-flops (11, 12; 44A, 44C),
    providing an input signal (ACin, $I_{RF}$, $V_{RF}$) having an input signal frequency to the first and second current mode logic flip-flops (11, 12; 44A, 44C),
    tapping output signals from the first and second current mode logic flip-flops (11, 12; 44A, 44C) which are based on a mixing of the input signal (ACin, $I_{RF}$, $V_{RF}$) with a local oscillator signal ($V_{LO,I+}$, $V_{LO,I-}$, $V_{LO,Q+}$, $V_{LO,Q1-}$) derived from the clock signal (clkin, $V_{CLK+}$, $V_{CLK-}$).

15. The method of claim 14, wherein the frequency divider has a division factor of N, and wherein the clock signal has a frequency N times the input signal frequency.

# Fig. 1

# Fig. 2

Fig. 3A

Fig. 3B

Fig. 4

Fig. 5

Fig. 6

73

78

LO

77

75    76

DETECTOR    $I_{out}$

72    $Q_{out}$

71    $\tau$    $A$

70    74

# Fig. 7

80

Apply AC input signal to flip flops

81

Apply clock signal to flip flops

82

Tap signal components from flip flops

# Fig. 8

Europäisches
Patentamt

European
Patent Office

Office européen
des brevets

# EUROPEAN SEARCH REPORT

Application Number

EP 18 24 8223

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | TANIGUCHI E ET AL: "A 2 GHz-band self frequency dividing quadrature mixer", 2005 IEEE RADIO FREQUENCY INTEGRATED CIRCUITS (RFIC) SYMPOSIUM; 12-14 JUNE 2005; LONG BEACH, CA, USA, IEEE, PISCATAWAY, NJ, USA, 12 June 2005 (2005-06-12), pages 505-508, XP010823180, DOI: 10.1109/RFIC.2005.1489858 ISBN: 978-0-7803-8983-0 | 1-4,8-15 | INV. H03D7/14 H03D7/16 |
| A | * page 506; figures 1,2 * | 5-7 | |
| A | US 2009/079497 A1 (SCHUUR AXEL [US] ET AL) 26 March 2009 (2009-03-26) * paragraphs [0033], [0034]; figure 1 * * paragraph [0063]; figure 5 * | 1-15 | |
| A | US 2014/253216 A1 (SOE ZAW [US] ET AL) 11 September 2014 (2014-09-11) * paragraphs [0038] - [0042]; figure 3A * | 1-15 | |

TECHNICAL FIELDS
SEARCHED (IPC)

H03D

The present search report has been drawn up for all claims

| Place of search | Date of completion of the search | Examiner |
|---|---|---|
| Munich | 14 June 2019 | Martínez Martínez, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 24 8223

This annex lists the patent family members relating to the patent documents cited in the above-mentioned European search report.
The members are as contained in the European Patent Office EDP file on
The European Patent Office is in no way liable for these particulars which are merely given for the purpose of information.

14-06-2019

| Patent document cited in search report | | Publication date | Patent family member(s) | | Publication date |
|---|---|---|---|---|---|
| US 2009079497 | A1 | 26-03-2009 | TW 200931789 A | | 16-07-2009 |
| | | | US 2009079497 A1 | | 26-03-2009 |
| | | | WO 2009038820 A1 | | 26-03-2009 |
| US 2014253216 | A1 | 11-09-2014 | NONE | | |

EPO FORM P0459

For more details about this annex : see Official Journal of the European Patent Office, No. 12/82